# EUROPEAN PATENT APPLICATION

(11) **EP 4 823 281 A1**
(43) Date of publication of application: **14.10.2026**
(21) Application number: 24899324.8
(22) Date of filing: 14.08.2024
(51) Int. Cl.: H10F 71/00, H10F 77/50, H10F 77/00, H10F 30/00

(54) **PHOTON DETECTOR AND PREPARATION METHOD THEREFOR**

(30) Priority: 04.12.2023 CN 202311656753; 22.02.2024 CN 202410201618
(71) Applicant: Sky Chip Interconnection Technology Co., Ltd, Shenzhen, Guangdong 518000 (CN)
(72) Inventor: XIONG, Yanchun, Shenzhen, Guangdong 518000 (CN); XIAO, Haoyang, Shenzhen, Guangdong 518000 (CN); SONG, Guanqiang, Shenzhen, Guangdong 518000 (CN); ZHANG, Weijie, Shenzhen, Guangdong 518000 (CN); MEN, Chuanbin, Shenzhen, Guangdong 518000 (CN); YU, Gongchi, Shenzhen, Guangdong 518000 (CN)
(74) Representative: Herrero & Asociados, S.L.
(86) International application number: PCT/CN2024/112132
(87) International publication number: WO 2025/118676

(57) **Abstract**

A photon detector and a preparation method therefor. The preparation method for the photon detector comprises: acquiring an adapter board (110), and flip-chip attaching at least one chip (130) onto one side of the adapter board (110) and fixedly connecting a plurality of first connectors (120) thereto; by means of the plurality of first connectors (120), connecting and fixing said side of the adapter board (110) to a first side (141) of a detection circuit board (140), so as to realize a connection between the chip (130) and the detection circuit board (140); and fixedly connecting a photoelectric conversion member (180) to the side of the adapter board (110) that is away from the detection circuit board (140), so as to obtain the photon detector. According to said method, by means of the adapter board (110), a connection between the photoelectric conversion member (180), the chip (130) and the detection circuit board (140) can be realized to realize the detection function of the photon detector, so that the manufacturing threshold for the photon detector can be reduced, thereby reducing the cost of the photon detector.

## Description

### TECHNICAL FIELD

The present disclosure relates to the technical field of photon detectors, and in particular to a photon detector and a manufacturing method thereof.

### BACKGROUND

A photon detector is a device used in a medical computed tomography (CT) and is one of the most important components of a CT machine. The photon detector can directly receive X-rays, convert the X-rays into current pulses, and then the current pulses may be converted into CT images through a series of image processing techniques for doctors to analyze medical conditions.

In the related art, packaging for a photon detector is achieved by connecting a chip and a photoelectric conversion member through a through silicon via (TSV).

However, connecting the chip and the photoelectric conversion member through the TSV requires customization, and the customization cost is relatively high.

### SUMMARY

The present disclosure provides a photon detector and a manufacturing method thereof to solve the problem of high manufacturing cost of photon detectors.

To solve the above technical problem, the present disclosure provides a manufacturing method of a photon detector, and the method includes: obtaining an adapter board, and flip-chip attaching at least one chip and fixedly connecting a plurality of first connecting members to one side of the adapter board; connecting and fixing the one side of the adapter board to a first side of a detection circuit board through the plurality of first connecting members, so as to achieve connection between the chip and the detection circuit board; and fixedly connecting a photoelectric conversion member to a side of the adapter board away from the detection circuit board to obtain the photon detector.

In some embodiments, flip-chip attaching the chip and fixedly connecting the plurality of first connecting members to the one side of the adapter board includes: welding and fixing the plurality of first connecting members to the one side of the adapter board; and welding a pin of the chip to the one side of the adapter board, and spacing the chip apart from the plurality of first connecting members.

In some embodiments, welding the pin of the chip to the one side of the adapter board, and spacing the chip apart from the plurality of first connecting members includes: filling a first filling material between the chip and the adapter board until a gap between the chip and the adapter board is fully filled.

In some embodiments, connecting and fixing the one side of the adapter board to the first side of the detection circuit board through the plurality of first connecting members includes: welding a side of each of the plurality of first connecting members away from the adapter board to the first side of the detection circuit board; and filling a second filling material between the adapter board and the detection circuit board until a gap between the adapter board and the detection circuit board is fully filled.

In some embodiments, before welding the side of each of the plurality of first connecting members away from the adapter board to the first side of the detection circuit board, the method includes: obtaining the detection circuit board, and attaching a plurality of electronic components and a first heat conduction member to a second side of the detection circuit board. The second side is opposite to the first side.

In some embodiments, before fixedly connecting the photoelectric conversion member to the side of the adapter board away from the detection circuit board to obtain the photon detector, the method includes: attaching a support heat-dissipation base to a side of the first heat conduction member away from the detection circuit board, so as to fixedly dispose the support heat-dissipation base on the second side of the detection circuit board.

In some embodiments, welding the side of each of the plurality of first connecting members away from the adapter board to the first side of the detection circuit board includes: disposing a second heat conduction member on the first side of the detection circuit board. A position of the second heat conduction member corresponds to a position of the chip; and welding the side of each of the plurality of first connecting members away from the adapter board to the first side of the detection circuit board, and enabling a side of the chip away from the adapter board to be in contact with the second heat conduction member.

In some embodiments, fixedly connecting the photoelectric conversion member to the side of the adapter board away from the detection circuit board to obtain the photon detector includes: disposing a plurality of second connecting members on the side of the adapter board away from the detection circuit board; correspondingly disposing a plurality of bonding members on one side of the photoelectric conversion member based on positions of the plurality of second connecting members; and bonding and fixing each of the plurality of bonding members to one corresponding second connecting member of the plurality of second connecting members to fixedly connect the photoelectric conversion member to the side of the adapter board away from the detection circuit board, and obtaining the photon detector.

In order to solve the above technical problem, the present disclosure provides a photon detector, and the photon detector is manufactured by any one of the above manufacturing methods of the photon detector. The photon detector includes the adapter board, the detection circuit board, and the photoelectric conversion member. The chip and the plurality of first connecting members are fixedly connected to the one side of the adapter board, the one side of the detection circuit board is fixedly connected to the one side of the adapter board through the plurality of first connecting members; and the photoelectric conversion member is fixedly connected to the side of the adapter board away from the detection circuit board.

In some embodiments, a plurality of second connecting members are disposed on a side of the adapter board away from the detection circuit board, a plurality of bonding members are correspondingly disposed on one side of the photoelectric conversion member, and each of the plurality of bonding members is bonded and fixed to one corresponding second connecting member of the plurality of bonding members to fixedly connect the photoelectric conversion member and the adapter board.

In order to solve the above technical problem, in the manufacturing method of the photon detector according to some embodiments, the photoelectric conversion member is fixedly connected to the side of the adapter board away from the detection circuit board. In this case, connection between the photoelectric conversion member, the chip, and the detection circuit board may be achieved through the adapter board, thereby achieving the detection function of the photon detector. The arrangement of the adapter board eliminates the need for a specially customized TSV connection structure for the photon detector, lowering the manufacturing threshold of the photon detector, reducing the cost of the photon detector, and facilitating the long-term development of photon detectors and the definition of future packaging forms.

### BRIEF DESCRIPTION OF THE DRAWINGS

FIG. 1 is a flowchart of a manufacturing method of a photon detector according to some embodiments of the present disclosure.
FIG. 2 is a flowchart of a manufacturing method of a photon detector according to some embodiments of the present disclosure.
FIG. 3 is a structural schematic view in the first half flowchart of FIG. 2 according to some embodiments of the present disclosure.
FIG. 4 is a structural schematic view in the latter half flowchart of FIG. 2 according to some embodiments of the present disclosure.
FIG. 5 is a structural schematic view of a photon detector according to some embodiments of the present disclosure.

### DETAILED DESCRIPTION

The technical solutions in the embodiments of the present disclosure will be described clearly and completely below with reference to the accompanying drawings in the embodiments of the present disclosure. Apparently, the described embodiments are only some embodiments of the present disclosure, not all embodiments of the present disclosure. Based on the embodiments in the present disclosure, all other embodiments obtained by those skilled in the art without creative efforts fall within the scope of the present disclosure.

It should be noted that when directional indications (such as above, lower, left, right, front, rear...) used in embodiments of the present disclosure are only used to explain relative position relationship, motion situation, etc. between components in a particular posture (as shown in the drawings). When the particular posture changes, the directional indication also changes accordingly.

In addition, when there are descriptions such as "first" and "second" in the embodiments of the present disclosure, such descriptions of "first" and "second" are only for descriptive purposes and cannot be understood as indicating or implying their relative importance or implicitly indicating the number of the indicated technical features. Thus, features defined with "first" and "second" may explicitly or implicitly include at least one of such features. In addition, the technical solutions in all embodiments can be combined with each other, but it must be based on what those skilled in the art can implement. When the combination of technical solutions is contradictory or cannot be implemented, it should be considered that such combination of technical solutions does not exist and is not within the scope claimed by the present disclosure.

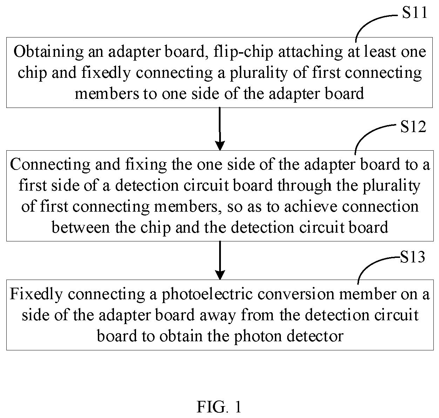

Referring to FIG. 1, FIG. 1 is a flowchart of a manufacturing method of a photon detector according to some embodiments of the present disclosure.

An operation S11 may include: obtaining an adapter board, flip-chip attaching at least one chip and fixedly connecting a plurality of first connecting members to one side of the adapter board.

The adapter board may include a single layer of a printed circuit board or a plurality of layers of printed circuit boards, and the number of the layers and the circuit may be set based on actual requirements. The adapter board may be a printed circuit board (PCB), a flexible printed circuit (FPC), or other forms of circuit board, which is not limited.

The chip may include an application specific integrated circuit (ASIC) chip or other photon detection chip, and the chip may be configured to process electrical signals converted from light absorbed by a photoelectric conversion member.

The first connecting members are configured to achieve electrical connection between the adapter board and a detection circuit board, and may include connection structures such as copper core balls, solder balls, metal posts, or metal bumps. etc. The material of the metal posts and metal bumps may include various metals such as copper, aluminum, silver, nickel, or alloys, and can be set based on actual requirements, which is not limited here.

At least one chip is flip-chip attached to one side of the adapter board and a plurality of first connecting members are fixedly connected to the one side of the adapter board. The number and positions of the chip and the first connecting members may be set based on actual requirements, which is not limited here.

Since the chip and the first connecting members are disposed on the same side of the adapter board, the chip and the first connecting members may be disposed spaced apart to avoid mutual interference.

An operation S12 may include: connecting and fixing the one side of the adapter board to a first side of a detection circuit board through the plurality of first connecting members, so as to achieve connection between the chip and the detection circuit board.

The detection circuit board is connected to the chip and the photoelectric conversion member through the adapter board to achieve the detection function of the photon detector.

The connection and fixation between the adapter board and the detection circuit board are achieved through the first connecting members disposed on the one side of the adapter board, thereby achieving the connection between the chip and the detection circuit board. After fixation, the chip is disposed between the adapter board and the detection circuit board. In some embodiments, the height of each of the first connecting members may be greater than the height of the chip, so that in a case where the first connecting members are connected to the adapter board and the detection circuit board, the chip may be accommodated in the space supported by the first connecting members. In this case, both the chip and the first connecting members are disposed between the adapter board and the detection circuit board, thereby improving device integration of the photon detector, reducing the overall volume of the photon detector, and thus achieving miniaturization of the photon detector.

An operation S13 may include: fixedly connecting a photoelectric conversion member on a side of the adapter board away from the detection circuit board to obtain the photon detector.

The photoelectric conversion member may be a cadmium zinc telluride (CZT) crystal. The CZT crystal can detect infrared rays, X-rays, gamma rays, other high-energy rays, and nuclear radiation. At room temperature, the CZT crystal can convert X-ray photons and gamma-ray photons into electrons, and may be configured to manufacture room-temperature X-ray detectors and gamma-ray detectors. In a case where the CZT crystal is applied to manufacturing a medical imaging equipment, the medical imaging equipment can present higher-definition images and significantly reduce radiation. The CZT crystal may be replaced by a semiconductor material such as cadmium telluride or monocrystalline silicon that may directly convert X-rays into electrical signals.

Through the above operations, in the manufacturing method of the photon detector according to some embodiments, the photoelectric conversion member is fixedly connected to the side of the adapter board away from the detection circuit board. In this case, connection between the photoelectric conversion member, the chip, and the detection circuit board may be achieved through the adapter board, thereby achieving the detection function of the photon detector. The arrangement of the adapter board eliminates the need for a specially customized TSV connection structure for the photon detector, lowering the manufacturing threshold of the photon detector, reducing the cost of the photon detector, and facilitating the long-term development of photon detectors and the definition of future packaging forms.

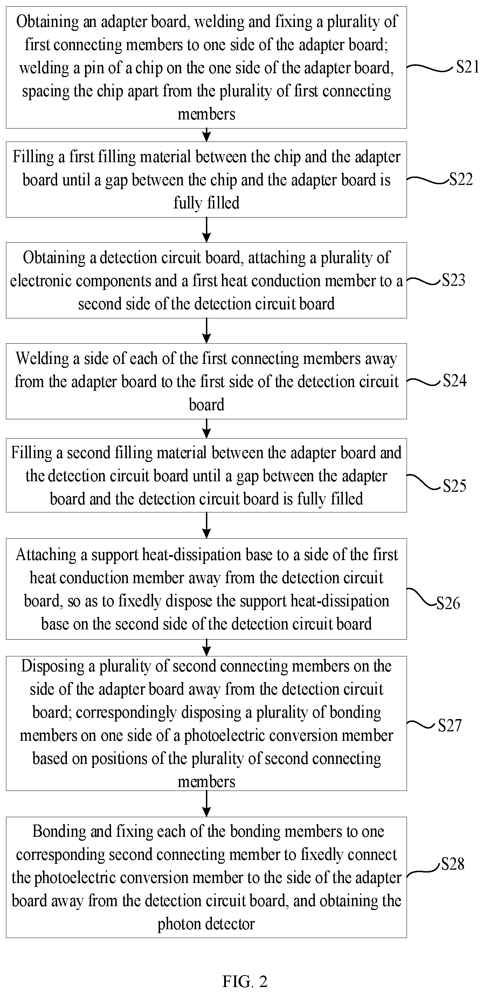

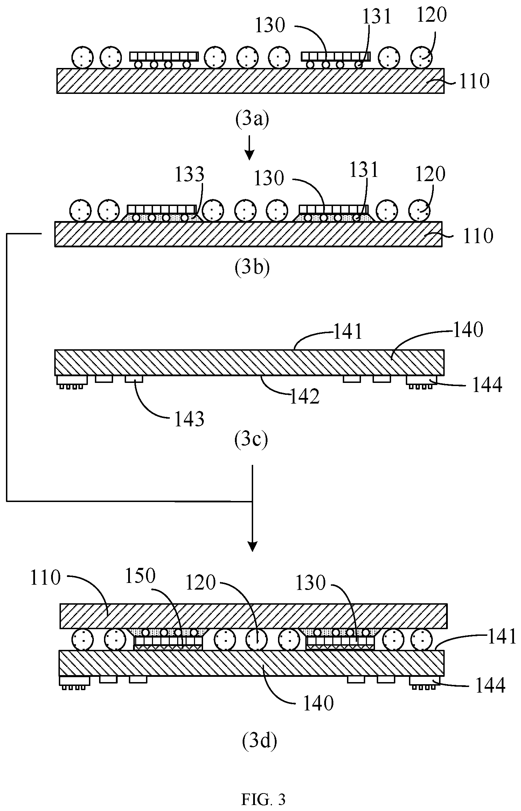

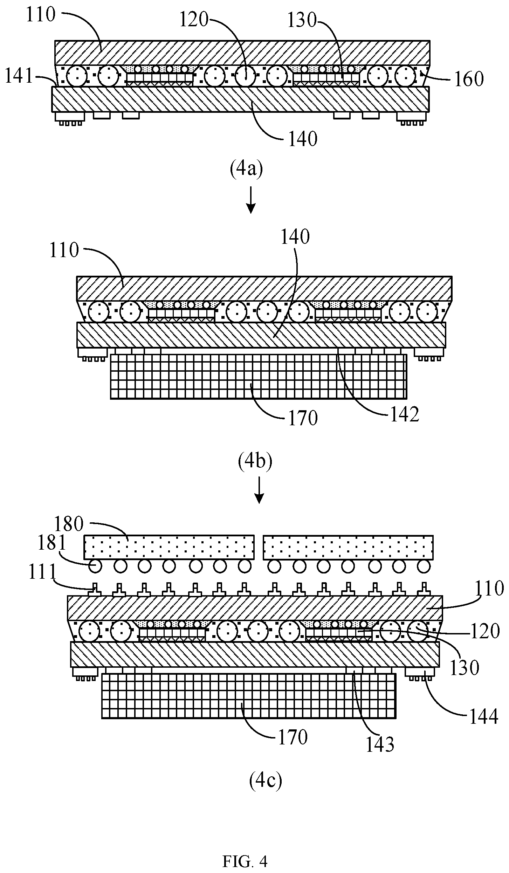

Referring to FIGS. 2-4, FIG. 2 is a flowchart of a manufacturing method of a photon detector according to some embodiments of the present disclosure, FIG. 3 is a structural schematic view in the first half flowchart of FIG. 2 according to some embodiments of the present disclosure, and FIG. 4 is a structural schematic view in the latter half flowchart of FIG. 2 according to some embodiments of the present disclosure.

An operation S21 may include: obtaining an adapter board, welding and fixing a plurality of first connecting members to one side of the adapter board; welding a pin of a chip on the one side of the adapter board, spacing the chip apart from the plurality of first connecting members.

Referring to FIG. 3a in FIG. 3, first, an adapter board 110 is obtained, a plurality of first connecting members 120 are welded and fixed to one side of the adapter board 110, and a pin 131 of a chip 130 is welded to the one side of the adapter board 110. That is, the chip 130 and the plurality of first connecting members 120 are welded and fixedly disposed on the same side of the adapter board 110. The chip 130 and the plurality of first connecting members 120 are spaced apart to avoid mutual interference.

In some embodiments, the first connecting members 120 may be evenly distributed on the one side of the adapter board 110 to facilitate subsequent flat support of the adapter board 100 and the detection circuit board.

The first connecting members 120 may include connection structures such as copper core balls, solder balls, metal posts, or metal bumps. This embodiment takes the first connecting members 120 as copper core balls as an example for illustration. In a case where the first connecting members 120 are other connection structures, their mounting and connection are similar to this embodiment and will not be repeated. This embodiment takes the number of the chip 130 as two as an example for illustration. In practical applications, the number of the chip 130 may be any other, such as 1, 3, 4, or 5, etc., which is not limited here.

An operation S22 may include: filling a first filling material between the chip and the adapter board until a gap between the chip and the adapter board is fully filled.

Further referring to FIG. 3b in FIG. 3, a first filling material 133 is filled between the chip 130 and the adapter board 110 until the gap between the chip 130 and the adapter board 110 is fully filled and the pin 131 is covered, so as to improve the structural stability between the chip 130 and the adapter board 110 through the first filling material 133, reduce the occurrence of loose connections, and improve the reliability of the photon detector.

The first filling material 133 may include one or more insulating materials such as filling glue, epoxy resins, polyester (PET), polyimide, polyimide-based materials, polycarbonate (PC), bismaleimide triazine (BT)-based materials, and ceramic-based materials, etc.

In this case, the chip 130, the first connecting members 120, and the adapter board 110 may form a semi-finished product assembly for backup, which may be directly used in subsequent processes.

An operation S23 may include: obtaining a detection circuit board, attaching a plurality of electronic components and a first heat conduction member to a second side of the detection circuit board.

In this operation, the detection circuit board is obtained first. In other embodiments, the detection circuit board may be a rigid-flex board, and include a main rigid portion, at least one flexible portion, and at least one side rigid portion. The flexible portion is perpendicularly disposed to the main rigid portion, so that the corresponding side rigid portion is perpendicularly disposed on a side of the detection circuit board away from the adapter board, to dispose electronic components and the adapter board on opposite sides of the main rigid portion of the detection circuit board. Each flexible portion may be connected to one corresponding side rigid portion, i.e., the number of flexible portion and side rigid portion may be the same, and the number can be set based on the mounting requirements of the electronic components, which is not limited here.

In some embodiments, after the detection circuit board is obtained, a plurality of electronic components are attached to opposite sides of the side rigid portion and/or on a side of the main rigid portion close to the side rigid portion. The positions of the electronic components may be anywhere on opposite sides of the side rigid portion and/or on the side of the main rigid portion close to the side rigid portion, which are not limited here. The side of the main rigid portion away from the side rigid portion is required to be connected to the adapter board.

In this embodiment, to increase the surface area of the detection circuit board, the side rigid portion is added to satisfy the mounting of the electronic components. In addition, to reduce the horizontal area of the detection circuit board, the flexible portion is disposed to achieve perpendicular arrangement between the side rigid portion and the main rigid portion, thereby reducing the horizontal area of the entire detection circuit board. This allows the horizontal area of the entire detection circuit board to be less than or equal to the horizontal area of the adapter board, thereby reducing the horizontal area of the entire detection circuit board while ensuring the functional requirements of the detection circuit board, and thus reducing the horizontal area of the photon detector and achieving miniaturization of the photon detector.

In this embodiment, the detection circuit board may be a sheet-like board, and electronic components and the adapter board are respectively disposed on opposite sides of the detection circuit board.

Further referring to FIG. 3c in FIG. 3, a detection circuit board 140 is obtained. A plurality of electronic components 144 and a first heat conduction member 143 are attached to a second side 142 of the detection circuit board 140. The second side 142 is opposite to a first side 141. The electronic components 144 are configured to assist the photon detector in achieving the detection function, and the first heat conduction member 143 is configured to achieve heat conduction with a support heat-dissipation base subsequently mounted.

The electronic components 144 may include but are not limited to connectors, resistors, capacitors, inductors, transformers, light-emitting diodes, crystal diodes, transistors, semiconductors, optocouplers, integrated circuits, chips, or relays, etc. A material of the first heat conduction member 143 refers to a high thermal conductivity material, which may include but is not limited to a metal material, a ceramic material, a polymer material, or a graphite material, etc. The polymer material may include but is not limited to polystyrene or polyurethane.

The position of the first heat conduction member 143 corresponds to the position of the support heat-dissipation base subsequently mounted. The electronic components 144 may be disposed on the edge of the second side 142 of the detection circuit board 140 to avoid the position of the support heat-dissipation base subsequently mounted and prevent stress collision.

An operation S24 may include: welding a side of each of the first connecting members away from the adapter board to the first side of the detection circuit board.

Further referring to FIG. 3d in FIG. 3, a second heat conduction member 150 may be first disposed on the first side 141 of the detection circuit board 140. The position of the second heat conduction member 150 corresponds to the position of the chip 130. A material of the second heat conduction member 150 refers to a high thermal conductivity material, which may include but is not limited to a metal material, a ceramic material, a polymer material, or a graphite material, etc. The polymer material may include but is not limited to polystyrene or polyurethane.

The side of each of the first connecting members 120 away from the adapter board 110 is welded to the first side 141 of the detection circuit board 140, and the side of the chip 130 away from the adapter board 110 is in contact with the second heat conduction member 150, so that heat generated by the working of the chip 130 may be conducted to the detection circuit board 140 through the second heat conduction member 150 and then dissipated through the detection circuit board 140, thereby improving the heat dissipation efficiency of the chip 130.

In some embodiments, solder paste may be printed on the first side 141 of the detection circuit board 140 at positions corresponding to the positions of the first connecting members 120, and then the first connecting members 120 of the previous semi-finished product assembly are correspondingly welded to the solder paste, thereby fixedly connecting the semi-finished product assembly including the chip 130, the first connecting members 120, and the adapter board 110 to the detection circuit board 140.

The height of each of the first connecting members 120 may be greater than the height of the chip 130, so that in a case where the first connecting members 120 are connected to the adapter board 110 and the detection circuit board 140, the chip 130 may be accommodated in the space supported by the first connecting members 120. In this case, both the chip 130 and the first connecting members 120 are disposed between the adapter board 110 and the detection circuit board 140, thereby improving device integration of the photon detector, reducing the overall volume of the photon detector, and thus achieving miniaturization of the photon detector.

In this case, the adapter board 110, the chip 130, and the detection circuit board 140 are stacked in sequence, and the detection circuit board 140 may achieve connection with the chip 130 through the adapter board 110.

An operation S25 may include: filling a second filling material between the adapter board and the detection circuit board until a gap between the adapter board and the detection circuit board is fully filled.

Further referring to FIG. 4a in FIG. 4, a second filling material 160 is filled between the adapter board 110 and the detection circuit board 140 until the gap between the adapter board 110 and the first side 141 of the detection circuit board 140 is fully filled and the first connecting members 120 are covered.

The second filling material 160 may include one or more insulating materials such as filling glue, epoxy resins, polyester (PET), polyimide, polyimide-based materials, polycarbonate (PC), bismaleimide triazine (BT)-based materials, and ceramic-based materials, etc.

Fully filling the gap between the adapter board 110 and the detection circuit board 140 with the second filling material 160 can enhance the structural rigidity between the adapter board 110 and the detection circuit board 140, thereby improving the bending strength between the adapter board 110 and the detection circuit board 140, and thus improving the structural stability of the photon detector. Moreover, the flatness between the adapter board 110 and the detection circuit board 140 fully filled with the second filling material 160 can be improved, thereby ensuring the flatness during subsequent mounting the photoelectric conversion member and facilitating mounting the photoelectric conversion member.

An operation S26 may include: attaching a support heat-dissipation base to a side of the first heat conduction member away from the detection circuit board, so as to fixedly dispose the support heat-dissipation base on the second side of the detection circuit board.

Further referring to FIG. 4b in FIG. 4, a support heat-dissipation base 170 is attached to the second side 142 of the detection circuit board 140 to support the subsequent mounting of the photoelectric conversion member. The support heat-dissipation base 170 may include but is not limited to a rigid plate member such as a metal plate member or a glass plate member, to provide support and heat dissipation functions for the photoelectric conversion member subsequently mounted.

In some embodiments, the support heat-dissipation base 170 is attached to the side of the first heat conduction member 143 away from the detection circuit board 140, so as to fixedly dispose the support heat-dissipation base 170 on the second side 142 of the detection circuit board 140. The support heat-dissipation base 170 is spaced apart from the electronic components 144.

One side of the detection circuit board 140 is connected to the support heat-dissipation base 170 through the first heat conduction member 143, thereby accelerating heat dissipation through the first heat conduction member 143 and the support heat-dissipation base 170, and improving the heat dissipation efficiency of the detection circuit board 140.

An operation S27 may include: disposing a plurality of second connecting members on the side of the adapter board away from the detection circuit board; correspondingly disposing a plurality of bonding members on one side of a photoelectric conversion member based on positions of the plurality of second connecting members.

Further refer to FIG. 4c in FIG. 4, a plurality of second connecting members 111 are disposed on the side of the adapter board 110 away from the detection circuit board 140, and a plurality of bonding members 181 are correspondingly disposed on one side of a photoelectric conversion member 180 based on positions of the plurality of second connecting members 111.

The second connecting members 111 may be connection structures such as metal bumps, metal pads, or metal posts, etc. The bonding members 181 may be, but are not limited to, copper paste, silver paste, indium posts, solder paste, or anisotropic conductive tape, etc. By performing low-temperature bonding the plurality of second connecting members 111 to corresponding bonding members 181, connection between the photoelectric conversion member 180 and the adapter board 110 may be achieved.

The photoelectric conversion member 180 may be a cadmium zinc telluride (CZT) crystal. The CZT crystal can detect infrared rays, X-rays, gamma rays, other high-energy rays, and nuclear radiation. At room temperature, the CZT crystal can convert X-ray photons and gamma-ray photons into electrons, and may be configured to manufacture room-temperature X-ray detectors and gamma-ray detectors. In a case where the CZT crystal is applied to manufacturing a medical imaging equipment, the medical imaging equipment can present higher-definition images and significantly reduce radiation. The CZT crystal may be replaced by a semiconductor material such as cadmium telluride or monocrystalline silicon that may directly convert X-rays into electrical signals.

The number of photoelectric conversion member 180 may be one or more, which is set based on actual requirements and is not limited here. The horizontal area of the photoelectric conversion member 180 does not exceed the horizontal area of the adapter board 110 to ensure the horizontal area of the photon detector.

An operation S28 may include: bonding and fixing each of the bonding members to one corresponding second connecting member to fixedly connect the photoelectric conversion member to the side of the adapter board away from the detection circuit board, and obtaining the photon detector.

Each of the bonding members 181 is bonded and fixed to one corresponding second connecting member 111 to fixedly connect the photoelectric conversion member 180 to the side of the adapter board 110 away from the detection circuit board 140, and the photon detector is obtained.

During the bonding and fixing process, the support heat-dissipation base 170 supports the detection circuit board 140 and the adapter board 110, improving the stability and flatness of the detection circuit board 140 and the adapter board 110, facilitating bonding and fixing the bonding members 181 to the corresponding second connecting members 111, ensuring stable and reliable connection.

In this case, the photoelectric conversion member 180 may achieve connection with the chip 130 through the bonding members 181, the second connecting members 111, and the adapter board 110 which are disposed sequentially, and achieve connection with the detection circuit board 140 through the bonding members 181, the second connecting members 111, the adapter board 110, and the first connecting members 120 which are disposed sequentially.

Through the above structure, the photon detector in some embodiments achieves connection between the photoelectric conversion member, the chip, and the detection circuit board through the adapter board, thereby achieving the detection function of the photon detector. The arrangement of the adapter board eliminates the need for a specially customized TSV connection structure for the photon detector, lowering the manufacturing threshold of the photon detector, reducing the cost of the photon detector, and facilitating the long-term development of photon detectors and the definition of future packaging forms. Moreover, in some embodiments, the first filling material is configured to fully fill the gap between the chip and the adapter board, improving the structural stability between the chip and the adapter board, reducing the occurrence of loose connections, and improving the reliability of the photon detector. Fully filling the gap between the adapter board and the detection circuit board with the second filling material can enhance the structural rigidity between the adapter board and the detection circuit board, thereby improving the bending strength between the adapter board and the detection circuit board, so as to improve the structural stability of the photon detector. Moreover, the flatness between the adapter board and the detection circuit board fully filled with the second filling material can be improved, thereby ensuring the flatness during subsequent mounting the photoelectric conversion member and facilitating mounting the photoelectric conversion member. Furthermore, the side of the chip away from the adapter board is in contact with the second heat conduction member, so that heat generated by the working of the chip may be conducted to the detection circuit board through the second heat conduction member and then dissipated through the detection circuit board, thereby improving the heat dissipation efficiency of the chip. Additionally, one side of the detection circuit board is connected to the support heat-dissipation base through the first heat conduction member, further accelerating heat dissipation through the first heat conduction member and the support heat-dissipation base, and further improving the heat dissipation efficiency of the chip.

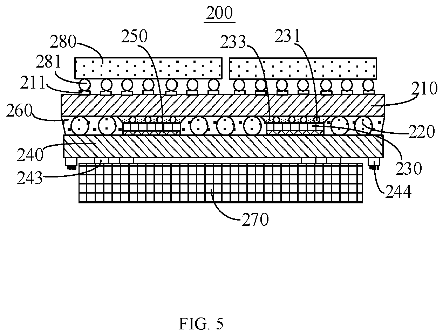

Refer to FIG. 5, FIG. 5 is a structural schematic view of a photon detector according to some embodiments of the present disclosure.

The photon detector 200 of this embodiment includes an adapter board 210, a detection circuit board 240, and a photoelectric conversion member 280.

At least one chip 230 and a plurality of first connecting members 220 are fixedly connected to one side of the adapter board 210. One side of the detection circuit board 240 is fixedly connected to the one side of the adapter board 210 through the first connecting members 220. The photoelectric conversion member 280 is fixedly connected to a side of the adapter board 210 away from the detection circuit board 240.

The photon detector 200 may be manufactured by any of the manufacturing methods of the photon detector in above embodiments.

Through the above structure, in this embodiment, connection between the photoelectric conversion member, the chip, and the detection circuit board may be achieved through the adapter board, thereby achieving the detection function of the photon detector. The arrangement of the adapter board eliminates the need for a specially customized TSV connection structure for the photon detector, lowering the manufacturing threshold of the photon detector, reducing the cost of the photon detector, and facilitating the long-term development of photon detectors and the definition of future packaging forms.

In other embodiments, a plurality of second connecting members 211 may be disposed on the side of the adapter board 210 away from the detection circuit board 240, a plurality of bonding members 281 may be correspondingly disposed on one side of the photoelectric conversion member 280, and each of the bonding members 281 is bonded and fixed to one corresponding second connecting member 211 to fixedly connect the photoelectric conversion member 280 to the adapter board 210.

The second connecting members 211 may be connection structures such as metal bumps, metal pads, or metal posts, etc. The bonding members 281 may be, but are not limited to, copper paste, silver paste, indium posts, solder paste, or anisotropic conductive tape, etc. By performing low-temperature bonding the plurality of second connecting members 211 to corresponding bonding members 281, connection between the photoelectric conversion member 280 and the adapter board 210 may be achieved.

The photoelectric conversion member 280 may be a cadmium zinc telluride (CZT) crystal. The CZT crystal can detect infrared rays, X-rays, gamma rays, other high-energy rays, and nuclear radiation. At room temperature, the CZT crystal can convert X-ray photons and gamma-ray photons into electrons, and may be configured to manufacture room-temperature X-ray detectors and gamma-ray detectors. In a case where the CZT crystal is applied to manufacturing a medical imaging equipment, the medical imaging equipment can present higher-definition images and significantly reduce radiation. The CZT crystal may be replaced by a semiconductor material such as cadmium telluride or monocrystalline silicon that may directly convert X-rays into electrical signals.

In other embodiments, a plurality of electronic components 244 and a first heat conduction member 243 may attached to a side of the detection circuit board 240 away from the adapter board 210. The electronic components 244 are configured to assist the photon detector in achieving the detection function, and the first heat conduction member 243 is configured to achieve heat conduction with a support heat-dissipation base subsequently mounted.

The electronic components 244 may include but are not limited to connectors, resistors, capacitors, inductors, transformers, light-emitting diodes, crystal diodes, transistors, semiconductors, optocouplers, integrated circuits, chips, or relays, etc. A material of the first heat conduction member 243 refers to a high thermal conductivity material, which may include but is not limited to a metal material, a ceramic material, a polymer material, or a graphite material, etc. The polymer material may include but is not limited to polystyrene or polyurethane.

The position of the first heat conduction member 243 corresponds to the position of the support heat-dissipation base 270. The electronic components 244 may be disposed on the edge of the second side 242 of the detection circuit board 240 to avoid the position of the support heat-dissipation base 270 and prevent stress collision.

One side of the detection circuit board 240 is connected to the support heat-dissipation base 270 through the first heat conduction member 243, thereby accelerating heat dissipation through the first heat conduction member 243 and the support heat-dissipation base 270, and further improving the heat dissipation efficiency of the detection circuit board 240.

In other embodiments, a support heat-dissipation base 270 is attached to the side of the detection circuit board 240 away from the adapter board 210 to support the mounting of the photoelectric conversion member 280. The support heat-dissipation base 270 may include but is not limited to a rigid plate member such as a metal plate member or a glass plate member, to provide support for the photoelectric conversion member 280 subsequently mounted.

In other embodiments, a second heat conduction member 250 is disposed on the side of the detection circuit board 240 away from the support heat-dissipation base 270. The position of the second heat conduction member 250 corresponds to the position of the chip 230. A material of the second heat conduction member 250 refers to a high thermal conductivity material, which may include but is not limited to a metal material, a ceramic material, a polymer material, or a graphite material, etc. The polymer material may include but is not limited to polystyrene or polyurethane

The side of the chip 230 away from the adapter board 210 is in contact with the second heat conduction member 250, so that heat generated by the working of the chip 230 may be conducted to the detection circuit board 240 through the second heat conduction member 250 and then dissipated through the detection circuit board 240 and the support heat-dissipation base 270, thereby improving the heat dissipation efficiency of the chip 230.

In other embodiments, a first filling material 233 is fully filled between a pin 231 of the chip 230 and the adapter board 210, so as to improve the structural stability between the chip 230 and the adapter board 210 through the first filling material 233, reduce the occurrence of loose connections, and improve the reliability of the photon detector.

In other embodiments, a second filling material 260 is fully filled between the adapter board 210 and the detection circuit board 240. The gap between the adapter board 210 and the detection circuit board 240 is fully filled with the second filling material 260, enhancing the structural rigidity between the adapter board 210 and the detection circuit board 240, improving the bending strength between the adapter board 210 and the detection circuit board 240, and improving the structural stability of the photon detector 200. Moreover, the flatness between the adapter board 210 and the detection circuit board 240 fully filled with the second filling material 260 can be improved, ensuring the flatness during subsequent mounting of the photoelectric conversion member 280, and facilitating the mounting of the photoelectric conversion member 280.

Through the above structure, the photon detector in some embodiments achieves connection between the photoelectric conversion member, the chip, and the detection circuit board through the adapter board, thereby achieving the detection function of the photon detector. The arrangement of the adapter board eliminates the need for a specially customized TSV connection structure for the photon detector, lowering the manufacturing threshold of the photon detector, reducing the cost of the photon detector, and facilitating the long-term development of photon detectors and the definition of future packaging forms. Moreover, in some embodiments, the first filling material is configured to fully fill the gap between the chip and the adapter board, improving the structural stability between the chip and the adapter board, reducing the occurrence of loose connections, and improving the reliability of the photon detector. Fully filling the gap between the adapter board and the detection circuit board with the second filling material can enhance the structural rigidity between the adapter board and the detection circuit board, thereby improving the bending strength between the adapter board and the detection circuit board, so as to improve the structural stability of the photon detector. Moreover, the flatness between the adapter board and the detection circuit board fully filled with the second filling material can be improved, thereby ensuring the flatness during subsequent mounting the photoelectric conversion member and facilitating mounting the photoelectric conversion member. Furthermore, the side of the chip away from the adapter board is in contact with the second heat conduction member, so that heat generated by the working of the chip may be conducted to the detection circuit board through the second heat conduction member and then dissipated through the detection circuit board, thereby improving the heat dissipation efficiency of the chip. Additionally, one side of the detection circuit board is connected to the support heat-dissipation base through the first heat conduction member, further accelerating heat dissipation through the first heat conduction member and the support heat-dissipation base, and further improving the heat dissipation efficiency of the chip.

The above are only some embodiments of the present disclosure, and are not intended to limit the scope of the present disclosure. Any equivalent structure or equivalent process transformation made using the contents in the description and drawings of the present disclosure, or directly or indirectly applied in other related technical fields, is included in the scope of the present disclosure.

## Claims

1. A manufacturing method of a photon detector, **characterized by** comprising:
obtaining an adapter board, and flip-chip attaching at least one chip and fixedly connecting a plurality of first connecting members to one side of the adapter board;
connecting and fixing the one side of the adapter board to a first side of a detection circuit board through the plurality of first connecting members, so as to achieve connection between the chip and the detection circuit board; and
fixedly connecting a photoelectric conversion member to a side of the adapter board away from the detection circuit board to obtain the photon detector.

2. The manufacturing method of the photon detector according to claim 1, wherein flip-chip attaching the chip and fixedly connecting the plurality of first connecting members to the one side of the adapter board comprises:
welding and fixing the plurality of first connecting members to the one side of the adapter board; and
welding a pin of the chip to the one side of the adapter board, and spacing the chip apart from the plurality of first connecting members.

3. The manufacturing method of the photon detector according to claim 2, wherein welding the pin of the chip to the one side of the adapter board, and spacing the chip apart from the plurality of first connecting members comprises:
filling a first filling material between the chip and the adapter board until a gap between the chip and the adapter board is fully filled.

4. The manufacturing method of the photon detector according to claim 3, wherein the first filling material comprises one or more insulating materials, and the insulating materials comprise filling glue, epoxy resins, polyester, polyimide, a polyimide-based material, polycarbonate, a bismaleimide triazine-based material, and a ceramic-based material.

5. The manufacturing method of the photon detector according to claim 1, wherein connecting and fixing the one side of the adapter board to the first side of the detection circuit board through the plurality of first connecting members comprises:
welding a side of each of the plurality of first connecting members away from the adapter board to the first side of the detection circuit board; and
filling a second filling material between the adapter board and the detection circuit board until a gap between the adapter board and the detection circuit board is fully filled.

6. The manufacturing method of the photon detector according to claim 5, wherein before welding the side of each of the plurality of first connecting members away from the adapter board to the first side of the detection circuit board, the method comprises:
obtaining the detection circuit board, and attaching a plurality of electronic components and a first heat conduction member to a second side of the detection circuit board, wherein the second side is opposite to the first side.

7. The manufacturing method of the photon detector according to claim 6, wherein the electronic components comprise connectors, resistors, capacitors, inductors, transformers, light-emitting diodes, crystal diodes, transistors, semiconductors, optocouplers, integrated circuits, chips, or relays.

8. The manufacturing method of the photon detector according to claim 6, wherein the detection circuit board is a rigid-flex board, and comprises a main rigid portion, at least one flexible portion, and at least one side rigid portion;
the flexible portion is perpendicularly disposed to the main rigid portion, each flexible portion is connected to one corresponding side rigid portion, and the number of the flexible portion is equal to the number of the side rigid portion.

9. The manufacturing method of the photon detector according to claim 6, wherein before fixedly connecting the photoelectric conversion member to the side of the adapter board away from the detection circuit board to obtain the photon detector, the method comprises:
attaching a support heat-dissipation base to a side of the first heat conduction member away from the detection circuit board, so as to fixedly dispose the support heat-dissipation base on the second side of the detection circuit board.

10. The manufacturing method of the photon detector according to claim 6, wherein welding the side of each of the plurality of first connecting members away from the adapter board to the first side of the detection circuit board comprises:
disposing a second heat conduction member on the first side of the detection circuit board, wherein a position of the second heat conduction member corresponds to a position of the chip; and
welding the side of each of the plurality of first connecting members away from the adapter board to the first side of the detection circuit board, and enabling a side of the chip away from the adapter board to be in contact with the second heat conduction member.

11. The manufacturing method of the photon detector according to claim 10, wherein each of the first heat conduction member and the second heat conduction member comprises a metal material, a ceramic material, a polymer material, or a graphite material.

12. The manufacturing method of the photon detector according to claim 1, wherein fixedly connecting the photoelectric conversion member to the side of the adapter board away from the detection circuit board to obtain the photon detector comprises:
disposing a plurality of second connecting members on the side of the adapter board away from the detection circuit board;
correspondingly disposing a plurality of bonding members on one side of the photoelectric conversion member based on positions of the plurality of second connecting members; and
bonding and fixing each of the plurality of bonding members to one corresponding second connecting member of the plurality of second connecting members to fixedly connect the photoelectric conversion member to the side of the adapter board away from the detection circuit board, and obtaining the photon detector.

13. A photon detector, **characterized in that** the photon detector is manufactured by the manufacturing method of the photon detector according to any one of claims 1-12, and at least comprises:
the adapter board, wherein the chip and the plurality of first connecting members are fixedly connected to the one side of the adapter board;
the detection circuit board, wherein the one side of the detection circuit board is fixedly connected to the one side of the adapter board through the plurality of first connecting members; and
the photoelectric conversion member, fixedly connected to the side of the adapter board away from the detection circuit board.

14. The photon detector according to claim 13, wherein a plurality of second connecting members are disposed on a side of the adapter board away from the detection circuit board, a plurality of bonding members are correspondingly disposed on one side of the photoelectric conversion member, and each of the plurality of bonding members is bonded and fixed to one corresponding second connecting member of the plurality of bonding members to fixedly connect the photoelectric conversion member and the adapter board.

15. The photon detector according to claim 14, wherein the plurality of bonding members comprise copper paste, silver paste, indium posts, solder paste, or anisotropic conductive tape.

16. The photon detector according to claim 13, wherein a plurality of electronic components and a first heat conduction member are attached to a side of the detection circuit board away from the adapter board, and the side of the detection circuit board is connected to the support heat-dissipation base through the first heat conduction member.

17. The photon detector according to claim 13, wherein a height of each of the plurality of first connecting members is greater than a height of the chip, so that the chip is capable of being accommodated in a space supported by the first connecting members.

18. The photon detector according to claim 13, wherein the photoelectric conversion member comprises cadmium zinc telluride, cadmium telluride, or monocrystalline silicon.

19. The photon detector according to claim 13, wherein the plurality of first connecting members comprise copper core balls, solder balls, metal posts, or metal bumps.
